# EUROPÄISCHE PATENTSCHRIFT

(11) **EP 2 878 182 B1**
(45) Veröffentlichungstag und Bekanntmachung des Hinweises auf die Patenterteilung: **07.09.2016**
(21) Anmeldenummer: 13739206.4
(22) Anmeldetag: 18.07.2013
(51) Int. Cl.: H05K 7/14

(54) **VERBINDUNGSSYSTEM**
CONNECTION SYSTEM
SYSTÈME DE LIAISON

(30) Priorität: 27.07.2012 DE 102012213258
(43) Veröffentlichungstag der Anmeldung: 03.06.2015
(73) Patentinhaber: Siemens Aktiengesellschaft, 80333 München (DE)
(72) Erfinder: MEIER, Markus, 92286 Rieden (DE); GEITNER, Manuel, 92289 Ursensollen (DE); HAUBNER, Peter, 90763 Fürth (DE); KNEIDL, Andreas, 92729 Weiherhammer (DE); ODÖRFER, Werner, 91238 Engelthal (DE); SACK, Christian, 92507 Nabburg (DE)
(86) Internationale Anmeldenummer: PCT/EP2013/065149
(87) Internationale Veröffentlichungsnummer: WO 2014/016190

(56) Entgegenhaltungen:
- WO-A1-00/25560
- DE-A1- 3 740 290
- DE-U- 7 113 834
- US-A- 4 790 762
- US-A- 6 081 048

## Beschreibung

Die Erfindung betrifft ein Verbindungssystem für Geräte, insbesondere Sicherheitsschaltgeräte, im Bereich der industriellen Automatisierungstechnik.

In der Industrieautomatisierung werden funktionale und logische Verknüpfungen mehrerer Geräte üblicherweise durch Verdrahtung der Geräte miteinander realisiert. Hierfür werden einzelne Anschlussstellen der Geräte jeweils mittels eines Drahts miteinander verbunden (Einzelverdrahtung). Derartige Verdrahtungen bergen jedoch das Risiko von Verdrahtungsfehlern bei der Erstinstallation, verursachen einen erheblichen Zeitaufwand bei der Erstinstallation, stellen ein Ausfallrisiko bezüglich des betriebenen Automatisierungssystems dar (z.B. durch Abvibrieren von Kabeln von den Anschlussstellen der Geräte oder durch Kontaktprobleme des Drahts an der Anschlussstelle) und bedürfen im Fall von Schraubklemmen einer Wartung (Nachziehen der Schrauben an den Anschlussstellen des Gerätes).

Aus DE 37 40 290 A1 ist eine Vorrichtung zum Steuern und/oder Regeln von Prozessen bekannt, die eine Mehrzahl von elektronischen Bausteinen zu Baugruppen verbunden sind, die jeweils auf einem Bus-Sockel-Modul angeordnet sind. Die Bus-SockelModule sind auf einer Hutprofil-Tragschiene aufgeklemmt und weisen seitlich jeweils eine Federleiste auf, die komplementär zu einer Messerleiste mit Pins ausgebildet ist. Die Messerleiste und die Federleiste sind an entgegengesetzten Seiten des Bus-Sockel-Moduls angeordnet und sind jeweils zur Vorderseite bzw. zur Rückseite des Bus-Sockel-Moduls offen. Eine Verbindung von Bus-Sockel-Modulen erfolgt in einer Bewegung senkrecht zu einer Längsachse der Hutprofil-Tragschiene. Eine mechanische und elektrische Verbindung zwischen zwei benachbarten Bus-Sockel-Modulen kommt zustande, wenn diese nacheinander auf die Hutprofil-Tragschiene aufgeklemmt werden.

Die Druckschrift US 6,081,048 A offenbart ein modulares erweiterbares Peripheriegerät mit einer selbstaufbauenden elektrischen Verbindung, das zur Steuerung und Überwachung eines technischen Prozesses geeignet ist. Das Peripheriegerät umfasst dabei Erweiterungsmodulunterteile EMU und Basismodulunterteile BMU, die eine anreihfähiges Profil aufweisen. In den Basismodulunterteilen BMU sind Kontaktelemente angeordnet, die als Messerleiste aus den Basismodulunterteilen BMU hervorstehen. In den Erweiterungsmodulunterteilen EMU sind Öffnungen ausgebildet, durch die einzelne Stifte in einer Messerleiste geführt werden können. Die Erweiterungsmodulunterteile EMU und die Basismodulunterteile BMU weisen in einer Seitenansicht ein Versatzprofil auf. Die einzelnen Stifte der Messerleisten, die in den Erweiterungsmodulunterteilen EMU aufgenommen sind, sind im Bereich einer Versatzstufe angeordnet, so dass ein seitliches Auseinanderziehen der Basismodulunterteile BMU und der Erweiterungsmodulunterteile EMU verhindert wird.

Aus DE 71 13 834 A1 ist eine Halterung für mehrere nebeneinandergereihte elektrische Geräteeinheiten bekannt, denen jeweils ein Halterungsabschnitt zugeordnet ist. Jeder Halterungsabschnitt umfasst ein Sockelbauteil, bei dem auf einer Sockelfläche mechanische Mittel zur lösbaren Befestigung der Geräteeinheiten angebracht sind. Jedes Sockelbauteil ist ferner an gegenüberliegenden Seitenflächen mit zueinander komplementären Verbindungsvorsprüngen und Steckausnehmungen versehen, die mit elektrischen Leitungsvorsprüngen verbunden sind. Die elektrischen Leitungsvorsprünge erlauben es, aufgesteckte Geräteeinheiten mit elektrischer Energie zu versorgen. Benachbarte Sockelbauteile sind durch Ineinanderstecken miteinander elektrisch verbindbar.

Die Patentschrift US 4,790,762 A offenbart eine erweiterbare Leiterrückwand, die dazu ausgebildet ist, elektrische Geräteeinheiten aufzunehmen und elektrisch miteinander zu verbinden. Die Leiterrückwand umfasst eine Mehrzahl an im Wesentlichen gleichen Rückwandmodulen, die an gegenüberliegenden Seitenflächen komplementär mit Zentrierstiften und röhrenförmigen Ausnehmungen versehen sind. Ferner sind an gegenüberliegenden Seitenwänden eines Rückwandmoduls elektrische Messerkontakte und Kontaktleisten angebracht. Bei einem Zusammenschieben von zwei Rückwandmodulen gewährleisten die Zentrierstifte in den röhrenförmigen Ausnehmungen eine mechanische Ausrichtung der Rückwandmodule zueinander. Die Messerkontakte und die Kontaktleisten von benachbarten Rückwandmodulen sind zueinander fluchtend ausgebildet, so dass beim Zusammenschieben der Rückwandmodule zwischen diesen eine elektrische Verbindung hergestellt wird. Über diese elektrische Verbindung werden Geräteeinheiten, die senkrecht zur Rückwandebene auf die Rückwandmodule aufgesteckt werden, mit Strom versorgt. Die auf den Rückwandmodulen aufgesteckten Geräteeinheiten werden bei der Montage mit Schrauben gesichert und bedecken mit ihrer Grundfläche im Wesentlichen die gesamte Fläche des Rückwandmoduls, die einem Benutzer zugewandt ist.

Aus WO00/25560 A1 ist eine modulares Anschlusssystem für elektrische Geräte bekannt, das Sockelmodule 50 umfasst, die an einer Hutschiene befestigt sind. Die Sockelmodule weisen an einer Seitenfläche Kontakte auf, die dazu ausgebildet sind, eine elektrische Verbindung zu einem benachbarten Sockelmodul herzustellen. Ferner sind Anschlüsse zur Übertragung von Signalen an den Seitenflächen der Sockelmodule ausgebildet. Auf einem einzelnen Sockelmodul kann ein elektrisches Gerät im Wesentlichen senkrecht zur Hutschiene aufgesteckt werden. Die Sockelmodule sind jeweils mit einer Zahnstange und einem Antriebsritzel versehen. Die Zahnstange und das Antriebsritzel jeweils benachbarter Sockelmodule greifen ineinander und gewährleisten eine gegenseitige Arretierung benachbarter Sockelmodule auf der Hutschiene.

Wird durch das Automatisierungssystem eine Sicherheitsapplikation abgedeckt (z.B. eine NOT-HALT-Abschaltung, eine Schutztür-Überwachung oder ein Schutz von Pressen oder Stanzen), so müssen die in der Sicherheitsapplikation eingesetzten Sicherheitsschaltgeräte erhöhte Sicherheitsanforderungen erfüllen. Derartige Sicherheitsschaltgeräte sind z.B. die Sicherheitsschaltgeräte SIRIUS 3TK28 der Firma SIEMENS. Mittels derartiger Sicherheitsschaltgeräte können insbesondere folgende sicherheitsgerichtete Funktionen zur Verfügung gestellt werden:
- Überwachung der Sicherheitsfunktionen von Sensoren,
- Überwachung von Sensorleitungen,
- Überwachung der korrekten Funktion des Sicherheitsschaltgerätes,
- Überwachung von Aktoren auf Stillstand,
- sicherheitsgerichtete Abschaltung von Gefährdungen.

Sicherheitsschaltgeräte sind somit die wesentlichen Bausteine einer Sicherheitskette innerhalb einer Sicherheitsapplikation eines Automatisierungssystems. Da die Anzahl der benötigten Eingänge, zur Überwachung der Sensoren/Aktoren, und Ausgänge, zum Ausgeben eines Sicherheitssignals, in Abhängigkeit des vorliegenden Sicherheitssystems variieren kann werden üblicherweise mehrere Sicherheitsschaltgeräte miteinander funktional und logisch verknüpft. Die funktionale und logische Verknüpfung der Sicherheitsschaltgeräte miteinander erfolgt üblicherweise mittels einer Einzelverdrahtung.

Der Erfindung liegt die Aufgabe zugrunde ein verbessertes sicheres Verbinden mindestens zweier Geräte, insbesondere Sicherheitsschaltgeräte, miteinander zu ermöglichen. Trotz Verbindung der Geräte miteinander soll vorzugsweise eine Hutschienenmontage und/oder Wandmontage der Geräte ermöglicht werden. Ferner soll vorzugsweise im eingebauten, elektrisch und mechanisch verbundenen Zustand mindestens zweier Geräte miteinander der Tausch eines der Geräte ohne Ausbau eines anderen Gerätes bzw. der Gesamteinheit ermöglicht werden. Des Weiteren ist vorzugsweise ein Einbau zwischen Kabelkanälen im Zeilenabstand von 120 mm möglich.

Mindestens eine dieser Aufgaben wird gelöst durch eine Vorrichtung gemäß Anspruch 1, d.h. durch ein Verbindungssystem für elektrische Geräte, mit einem ersten und einem zweiten Verbindungsmodul, welches jeweils ein erstes Anschlussmittel aufweist, wobei das erste Verbindungsmodul ein zweites Anschlussmittel aufweist und das zweite Verbindungsmodul ein drittes Anschlussmittel aufweist, wobei das erste und zweite Verbindungsmodul jeweils ein Gerät aufnehmen kann, so dass im gekoppelten Zustand des Geräts mit dem Verbindungsmodul eine unmittelbare elektrische Verbindung zwischen dem ersten Anschlussmittel des Verbindungsmoduls und dem aufgenommenen Gerät und eine unmittelbare mechanische Verbindung zwischen dem Verbindungsmodul und dem aufgenommenen Gerät vorliegt, wobei das erste Verbindungsmodul mit seinem zweiten Anschlussmittel unmittelbar mit dem dritten Anschlussmittel des zweiten Verbindungsmoduls verrastet werden kann, so dass im verrasteten Zustand das erste Verbindungsmodul elektrisch und mechanisch mit dem zweiten Verbindungsmodul verbunden ist, wobei das dritte Anschlussmittel derart angeordnet und ausgebildet ist, dass im verrasteten Zustand des zweiten Anschlussmittels mit dem dritten Anschlussmittel ein mechanisches und elektrisches Trennen des ersten Verbindungsmoduls von dem zweiten Verbindungsmodul verhindert wird, wenn das zweite Verbindungsmodul ein Gerät aufgenommen hat.

Vorteilhafte Weiterbildungen der Erfindung sind in den abhängigen Ansprüchen 2 bis 13 angegeben.

Der mit der Erfindung erzielte Vorteil besteht darin, dass eine Einzelverdrahtung zwischen den Geräten entfallen kann. Zur elektrischen und mechanischen Verbindung der einzelnen Geräte miteinander müssen zunächst lediglich die einzelnen Verbindungsmodule miteinander gekoppelt werden. Hierbei wird das zweite Anschlussmittel des ersten Verbindungsmoduls unmittelbar mit dem dritten Anschlussmittel des zweiten Verbindungsmoduls verrastet. Durch das Koppeln der beiden Verbindungsmodule miteinander wird eine elektrisch leidende Verbindung zwischen dem zweiten und dritten Anschlussmittel hergestellt. Hierfür umfasst das zweite und dritte Anschlussmittel jeweils mindesten ein elektrisches Kontaktelement. Durch das Koppeln der beiden Verbindungsmodule miteinander kontaktiert das mindestens eine Kontaktelement des zweiten Anschlussmittels das mindestens eine Kontaktelement des dritten Anschlussmittels. Ferner werden durch das Verrasten der Verbindungsmodule miteinander die Verbindungsmodule miteinander mechanisch verbunden. Diese Verbindung ist insbesondere eine mechanisch lösbare Verbindung; d.h. das erste Verbindungsmodul kann ohne Zerstörung des ersten oder zweiten Verbindungsmoduls wieder von dem zweiten Verbindungsmodul getrennt werden. Zum zerstörungsfreien Trennen des ersten Verbindungsmoduls vom zweiten Verbindungsmodul darf das zweite Verbindungsmodul jedoch kein Gerät aufgenommen haben.

Das erste Anschlussmittel des ersten Verbindungsmoduls ist elektrisch leitend mit dem zweiten Anschlussmittel des ersten Verbindungsmoduls verbunden. Das erste Anschlussmittel des zweiten Verbindungsmoduls ist elektrisch leitend mit dem dritten Anschlussmittel des zweiten Verbindungsmoduls verbunden.

Zum elektrischen Verbinden eines ersten Gerätes mit einem zweiten Gerät müssen die Geräte lediglich mit zwei bereits miteinander verrasteten Verbindungsmodulen gekoppelt werden. Hierfür werden das erste Gerät mit dem ersten Verbindungsmodul und das zweite Gerät mit dem zweiten Verbindungsmodul gekoppelt. Durch das Koppeln der Geräte mit dem zugehörigen Verbindungsmodul erfolgt eine elektrische Kontaktierung des Geräts, insbesondere einer Anschlussstelle des Gerätes, mit dem ersten Anschlussmittel des zugehörigen Verbindungsmoduls. Die Geräte werden vorzugsweise mittels einer Verrastung (Rastverbindung) mit dem Verbindungsmodul gekoppelt.

Durch das Koppeln des zweiten Verbindungsmoduls mit einem Gerät wird das dritte Anschlussmittel derart blockiert, dass ein mechanisches Trennen des dritten Anschlussmittels vom zweiten Anschlussmittel verhindert wird. Hierdurch kann sichergestellt werden, dass ein unbeabsichtigtes Trennen der elektrischen Verbindung zwischen zwei Geräten, welche mittels des ersten und zweiten Verbindungsmoduls miteinander verbunden sind, verhindert wird.

Durch das Verbindungssystem wird insbesondere ein sicheres, übersichtliches mechanisches und elektrisches Verbinden zweier Geräte miteinander ermöglicht.

In einer vorteilhaften Ausführungsform der Erfindung ist das erste Verbindungsmodul baugleich zum zweiten Verbindungsmodul. Das erste und zweite Verbindungsmodul, weist somit jeweils auf einer Seite das zweite elektrische Anschlussmittel und auf der gegenüberliegenden Seite das dritte elektrische Anschlussmittel auf.

Dadurch dass die Verbindungsmodule gleich aufgebaut sind, kann dass Verbindungssystem beliebig erweitert werden. Zum sicheren elektrischen und mechanischen Verbinden dreier Geräte müssen somit lediglich drei Verbindungsmodule miteinander verbunden und anschließend die einzelnen Geräte jeweils mit einem der verbundenen Verbindungsmodule gekoppelt werden.

Das erste Anschlussmittel eines Verbindungsmoduls ist insbesondere geräteintern elektrisch leitend mit dem zweiten Anschlussmittel und dem dritten Anschlussmittel verbunden. Insbesondere umfasst das erste Anschlussmittel mindestens ein erstes Kontaktelement, welches elektrisch leitend mit einem Kontaktelement des zweiten Anschlussmittels verbunden ist und mindestens ein zweites Kontaktelement, welches elektrisch leitend mit einem Kontaktelement des dritten Anschlussmittels verbunden ist.

Sofern das Verbindungsmodul kein Gerät aufgenommen hat, so liegt insbesondere keine elektrisch leitende Verbindung zwischen den Kontaktelementen des zweiten und dritten Anschlussmittels des Verbindungsmoduls vor. Durch das Aufnehmen eines Gerätes im Verbindungsmodul liegt in Abhängigkeit des Zustandes des aufgenommenen Gerätes eine elektrisch leitende Verbindung zwischen dem zweiten und dritten Anschlussmittel vor.

Beim mechanischen Koppeln zweier Verbindungsmodule wird das Kontaktelement des zweiten Anschlussmittels elektrisch leitend mit dem zugehörigen Kontaktelement des dritten Anschlussmittels verbunden.

In einer weiteren vorteilhaften Ausführungsform der Erfindung umfasst das erste und zweite Verbindungsmodul jeweils ein Rastmittel, mittels welchem die mechanische Verbindung zu dem Gerät herstellbar ist. Das Rastmittel ist vorzugsweise als Schnappvorrichtung ausgebildet. Insbesondere umfasst das Verbindungsmodul hierfür mindestens eine Schnappnase.

Die unmittelbare mechanische Verbindung des Verbindungsmoduls mit dem Gerät ist vorzugsweise eine lösbare Schnappverbindung.

In einer weiteren vorteilhaften Ausführungsform der Erfindung weist das erste und zweite Verbindungsmodul jeweils eine Hutschienenaufnahme auf. Die Hutschienenaufnahme liegt insbesondere der Seite gegenüber, welche das erste Anschlussmittel aufweist. Mittels der Hutschienenaufnahme kann das Verbindungsmodul auf einer Hutschiene befestigt, insbesondere verrastet, werden. Auf diese Weise kann eine äußerst flexible Befestigung der Geräte mittels des Verbindungsmoduls erfolgen.

Die mechanische Kontaktierung des Gerätes mit dem Verbindungsmodul erfolgt vorzugsweise über den Gehäuseboden des Gerätes. Hierdurch kann eine besonders übersichtliche Installation der Geräte gewährleistet werden. Das Gerät weist vorzugsweise am Gehäuseboden ebenso eine Hutschienenaufnahme auf.

Die Hutschienenaufnahme des Verbindungsmoduls und/oder des Gerätes ist insbesondere derart ausgebildet, dass eine lösbare Verbindung mit einer 35 mm Hutschiene mit einer Tiefe von 15 mm oder 7,5 mm erfolgen kann.

In einer weiteren vorteilhaften Ausführungsform der Erfindung erfolgt die unmittelbare mechanische Verbindung zwischen dem ersten Verbindungsmodul mit dem zweiten Verbindungsmodul mittels einer lösbaren Schnappverbindung.

In einer weiteren vorteilhaften Ausführungsform der Erfindung weist das zweite Anschlussmittel eine Schnappnase auf, welche in einen Schnappnasengegenspieler des dritten Anschlussmittels einrasten kann. Die mechanische Verbindung der Verbindungsmodule miteinander erfolgt somit mittels einer Schnappverbindung zwischen der Schnappnase und dem Schnappnasengegenspieler.

In einer weiteren vorteilhaften Ausführungsform der Erfindung wird während des mechanischen Koppelns des ersten Verbindungsmoduls mit dem zweiten Verbindungsmodul ein Teil des dritten Anschlussmittels ausgelenkt.

Insbesondere wird während des Koppelns der Teil des dritten Anschlussmittels in den Bereich des Verbindungsmoduls ausgelenkt, welcher durch das Gerät im gekoppelten Zustand mit dem Verbindungsmodul eingenommen wird. Dieser Bereich wird wie folgt Gerätebereich genannt.

Der ausgelenkte Teil des dritten Anschlussmittels umfasst vorzugsweise den Schnappnasengegenspieler, so dass während des Koppelns des ersten Verbindungsmoduls mit dem zweiten Verbindungsmodul der Schnappnasengegenspieler (z.B. eine Lasche, in welche die Schnappnase einrasten kann), insbesondere in den Gerätebereich, ausgelenkt wird.

Wurde das zweite Verbindungsmodul bereits mit einem Gerät gekoppelt, so kann keine Verrastung des ersten Verbindungsmoduls über sein zweites Anschlussmittel mit dem dritten Anschlussmittel des zweiten Verbindungsmoduls erfolgen, da ein Auslenken des Teils des zweiten Verbindungsmoduls durch das aufgenommene Gerät verhindert wird.

Wurde das erste Verbindungsmodul über sein zweites Anschlussmittel mit dem dritten Anschlussmittel des zweiten Verbindungsmoduls verrastet und anschließend das zweite Verbindungsmodul mit einem Gerät gekoppelt, so wird durch das aufgenommene Gerät der Gerätebereiche eingenommen. Ein Trennen des ersten Verbindungsmoduls vom zweiten Verbindungsmodul ist nicht möglich, da hierfür ein Teil des dritten Anschlussmittels in den Gerätebereich ausgelenkt werden muss. Dieser Gerätebereich ist jedoch vom aufgenommen Gerät eingenommen.

Bei dem Koppeln/Aufnehmen des Gerätes mit dem Verbindungsmodul wird insbesondere das Gerät mit dem Verbindungsmodul derart verrastet, dass ein unbeabsichtigtes Lösen des Geräts vom Verbindungsmodul verhindert wird.

Das Verbindungsmodul, welches mittels seines dritten Anschlussmittels mit einem nebengeordneten Verbindungsmodul gekoppelt ist, kann somit im gekoppelten Zustand mit einem Gerät nicht vom nebengeordneten Verbindungsmodul getrennt werden. Wird das aufgenommene Gerät vom Verbindungsmodul entfernt, so können die beiden Verbindungsmodule voneinander getrennt werden.

Durch ein derartiges Verbindungssystem kann somit ein sicheres mechanisches und elektrisches Verbinden zweier Geräte miteinander gewährleistet werden.

Es versteht sich von selbst, dass die Verrastung des zweiten Anschlussmittels mit dem dritten Anschlussmittel invers erfolgen kann. Anstelle der Auslenkung eines Teils des dritten Anschlussmittels des zweiten Verbindungsmoduls, während der mechanischen Verbindung mit dem zweiten Anschlussmittel des ersten Verbindungsmoduls, kann ebenso ein Teil des zweiten Anschlussmittels derart ausgebildet sein, dass es während der mechanischen Verbindung mit dem dritten Anschlussmittel in den Gerätebereich des zweiten Verbindungsmoduls ausgelenkt wird. Das zweite Anschlussmittel wäre somit derart angeordnet und ausgebildet, dass im gekoppelten Zustand des zweiten Anschlussmittels mit dem dritten Anschlussmittel ein mechanisches und elektrisches Trennen des ersten Verbindungsmoduls von dem zweiten Verbindungsmodul verhindert wird, wenn das zweite Verbindungsmodul ein Gerät aufgenommen hat.

In einer weiteren vorteilhaften Ausführungsform der Erfindung weist das erste und zweite Verbindungsmodul jeweils ein Befestigungsmittel zum Befestigen des Verbindungsmoduls mittels einer Schraube auf. Das Befestigungsmittel zum Befestigen des Verbindungsmoduls z.B. an einer Wand ist vorzugsweise durch eine Aussparung ausgebildet, über welche das Verbindungsmodul, z.B. mittels einer Schraube, an der Wand befestigt werden kann.

In einer weiteren vorteilhaften Ausführungsform der Erfindung umfasst das zweite und dritte Anschlussmittel eines Verbindungsmoduls jeweils mindestens zwei elektrische Kontaktelemente, welche jeweils geräteintern zu einem Kontaktelement des ersten Anschlussmittels geführt sind.

In einer weiteren vorteilhaften Ausführungsform der Erfindung umfasst das Verbindungssystem ein drittes Verbindungsmodul, welches ein erstes Anschlussmittel aufweist, wobei das dritte Verbindungsmodul ein Gerät aufnehmen kann, so dass im gekoppelten Zustand des Geräts mit dem dritten Verbindungsmodul eine unmittelbare elektrische Verbindung zwischen dem ersten Anschlussmittel des dritten Verbindungsmoduls und dem aufgenommenen Gerät und eine unmittelbare mechanische Verbindung zwischen dem dritten Verbindungsmodul und dem aufgenommenen Gerät vorliegt, wobei das dritte Verbindungsmodul ein drittes Anschlussmittel aufweist, wobei das zweite Anschlussmittel des ersten oder zweiten Verbindungsmoduls unmittelbar mit dem dritten Anschlussmittel des dritten Verbindungsmoduls verrastet werden kann, so dass im verrasteten Zustand das zweite Anschlussmittel des ersten oder zweiten Verbindungsmoduls elektrisch und mechanisch mit dem dritten Verbindungsmodul verbunden ist, wobei das dritte Anschlussmittel derart angeordnet und ausgebildet ist, dass im verrasteten Zustand des zweiten Anschlussmittels mit dem dritten Anschlussmittel ein mechanisches und elektrisches Trennen des Verbindungsmoduls des zweiten Anschlussmittels von dem dritten Verbindungsmodul verhindert wird, wenn das dritte Verbindungsmodul ein Gerät aufgenommen hat, wobei das dritte Verbindungsmodul ein Abschlussmittel umfasst, mittels welchem elektrische Kontaktelemente des ersten Anschlussmittels miteinander verbunden werden können.

Das dritte Anschlussmittel des dritten Verbindungsmoduls ist insbesondere baugleich zum dritten Anschlussmittel des zweiten und/oder ersten Verbindungsmoduls ausgebildet.

Vorzugsweise werden Kontaktelemente des ersten Anschlussmittels des dritten Verbindungsmoduls geräteintern zum dritten Anschlussmittel des dritten Verbindungsmoduls geführt.

Das dritte Verbindungsmodul kann somit als abschließendes Verbindungsmodul verwendet werden. Dadurch, dass mittels des Abschlussmittels elektrische Kontaktelemente des ersten Anschlussmittels miteinander verbunden werden können, können über das dritte Anschlussmittel eingehende elektrische Signale über das erste Anschlussmittel zum aufgenommenen Gerät geführt werden. Das erste Gerät kann die elektrischen Signale auswerten und anschließend an das erste Anschlussmittel ausgeben. Die ansonsten zum zweiten Anschlussmittel des nebengeordneten Verbindungsmoduls geführten Signale werden nun geräteintern im dritten Verbindungsmodul mittels des Abschlussmittels verschaltet, so dass sie zum ersten Anschlussmittel zurückgeführt werden.

Eine über das Gerät des ersten Verbindungsmoduls gesteuerter Freigabekreis und überwachter Rückführkreis kann somit mittels des Abschlussmittels zurückgeführt werden, so dass seitens des Gerätes des ersten Verbindungsmoduls eine entsprechende Auswertung erfolgen kann. Das Abschlussmittel ist vorzugsweise ein Schalter, welcher in einer ersten Stellung eine elektrisch leitende Verbindung zwischen Kontaktelementen des ersten Anschlussmittels herstellt und in einer zweiten Stellung eine elektrisch leitende Verbindung zwischen Kontaktelementen des ersten Anschlussmittels unterbindet.

Die Verbindungsmodule sind vorzugsweise derart ausgebildet, dass sie jeweils ein gleiches Gerät aufnehmen können.

In einer weiteren vorteilhaften Ausführungsform der Erfindung liegt ein System einem Verbindungssystem und einem ersten und zweiten Gerät vor. Das erste Gerät ist mit dem ersten Verbindungsmodul und das zweite Gerät mit dem zweiten Verbindungsmodul koppelbar.

Die Geräte sind vorzugsweise bezüglich der Verrastung mit dem Verbindungsmodul baugleich ausgebildet.

Das erste und zweite Gerät ist vorzugsweise jeweils ein elektrisches Gerät, insbesondere ein Sicherheitsschaltgerät. Mit dem Sicherheitsschaltgerät können vorzugsweise folgende sicherheitsgerichtete Funktionen zur Verfügung gestellt werden:
- Überwachung der Sicherheitsfunktionen von Sensoren,
- Überwachung von Sensorleitungen,
- Überwachung der korrekten Funktion des Sicherheitsschaltgerätes,
- Überwachung von Aktoren auf Stillstand und/oder
- sicherheitsgerichtete Abschaltung von Gefährdungen.

Das Sicherheitssystem umfasst vorzugsweise als erstes Sicherheitsschaltgerät ein Grundmodul und als zweites Sicherheitsschaltgerät ein Erweiterungsmodul.

Das Grundmodul umfasst vorzugsweise Sicherheitseingänge, Sicherheitsausgänge und eine Auswerteeinheit. Mittels der Auswerteeinheit können die Sicherheitseingänge eingelesen und die Sicherheitsausgänge angesteuert werden.

Das Grundmodul umfasst vorzugsweise ein Interfacemodul, mittels welchem das Grundmodul mit einer übergeordneten Steuerung kommunizieren kann (z.B. über PROFIBUS oder AS-Interface). Im Grundmodul wird vorzugsweise das gesamte Sicherheitsprogramm einer Sicherheitsapplikation abgearbeitet.

Mittels des Erweiterungsmoduls kann das Sicherheitssystem flexibel an die geforderte Sicherheitsapplikationen angepasst werden. Durch das Erweiterungsmodul kann die Anzahl der verfügbaren Sicherheitseingänge und/oder Sicherheitsausgänge erweitert werden. Das Sicherheitssystem kann vorzugsweise mit mehreren Erweiterungsmodulen erweitert werden. Zur elektrischen und mechanischen Anbindung der Sicherheitsschaltgeräte untereinander müssen lediglich mehrere Verbindungsmodule miteinander verbunden werden.

In einer weiteren vorteilhaften Ausführungsform der Erfindung ist das erste Gerät ein Grundmodul und das zweite Gerät ein Erweiterungsmodul, wobei im gekoppelten Zustand des Grundmoduls mit dem ersten Verbindungsmodul, des Erweiterungsmoduls mit dem zweiten Verbindungsmoduls und des ersten Verbindungsmoduls mit dem zweiten Verbindungsmodul, das Grundmodul ein elektrisches Signal über das erste und zweite Verbindungsmodul an das Erweiterungsmodul ausgeben kann.

Das Grundmodul umfasst vorzugsweise eine Auswerteeinheit mittels welchem ein Freigabekreis und Rückführkreis des Sicherheitssystems ausgewertet werden kann.

Die Ausgabe eines Signals an einem Sicherheitsausgang des Erweiterungsmoduls wird insbesondere lediglich durch das Grundmodul gesteuert.

In einer weiteren vorteilhaften Ausführungsform der Erfindung umfasst das erste und zweite Gerät jeweils eine Leiterplatte mit einer elektrisch leitenden Kontaktfläche, wobei das elektrische Kontaktieren des Geräts zur ersten Anschlussstelle direkt über die elektrisch leitende Kontaktfläche auf der Leiterplatte erfolgt.

In einer weiteren vorteilhaften Ausführungsform der Erfindung weist das Gerät im Bereich der Hutschienenaufnahme eine Kontaktstelle zum elektrischen Kontaktieren des Geräts mit der ersten Anschlussstelle auf. Die Kontaktstelle ist insbesondere im Bereich der durch die Hutschienenaufnahme gebildeten Aussparung am Gerät angeordnet. Hierdurch kann eine äußert kompakte Geräteeinheit zwischen dem Verbindungsmodul und dem im Verbindungsmodul aufgenommenen Gerät gebildet werden.

Das Verbindungssystem ist vorzugsweise derart ausgebildet, dass in den Geräten lediglich eine Steckfläche (z.B. über die Leiterplatte) bereitgestellt werden muss. Die Stecktechnik selbst ist über das erste Anschlussmittel im Verbindungsmodul eingebaut. Auf diese Weise können Zusatzkosten am Gerät vermieden werden.

Im Folgenden werden die Erfindung und Ausgestaltungen der Erfindung anhand der in den Figuren dargestellten Ausführungsbeispiele näher beschrieben und erläutert. Es zeigen:
- FIG 1: eine schematische Darstellung eines ersten Verbindungsmoduls,
- FIG 2: eine weitere schematische Darstellung des ersten Verbindungsmoduls der gemäß der FIG 1,
- FIG 3: eine schematische Darstellung eines dritten Verbindungsmoduls,
- FIG 4: eine weitere schematische Darstellung des dritten Verbindungsmoduls gemäß der FIG 3,
- FIG 5: eine schematische Darstellung eines Schnittbildes von drei Verbindungsmodulen,
- FIG 6: eine schematische Darstellung eines Ausschnitts einer Draufsicht der drei Verbindungsmodule gemäß der FIG 5,
- FIG 7: eine schematische Darstellung eines Schnittbildes von drei miteinander verrasteten Verbindungsmodulen, und
- FIG 8: eine schematische Darstellung eines Systems mit drei Verbindungsmodulen und drei Geräten.

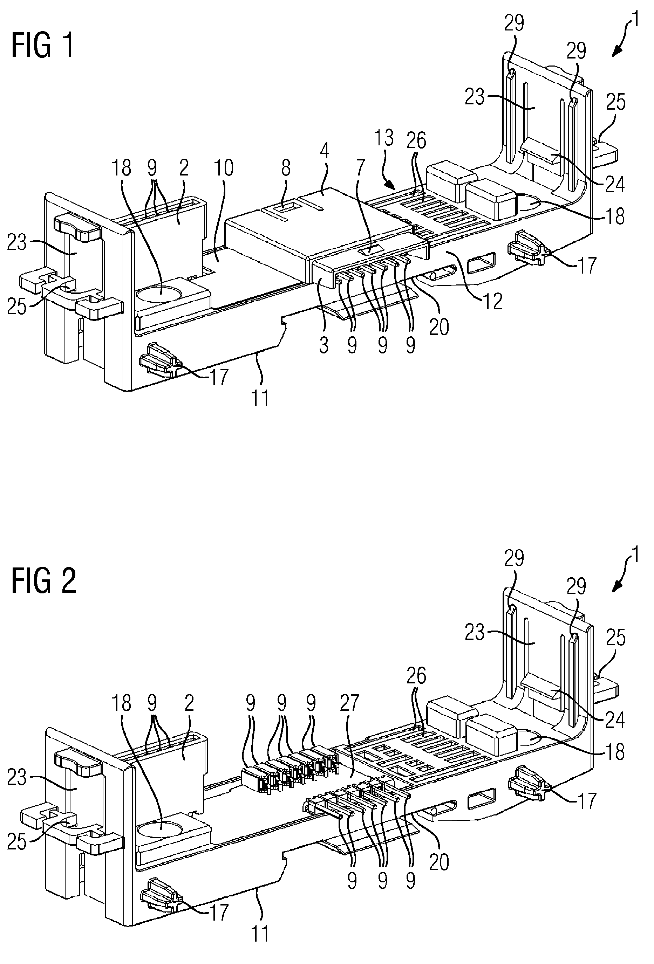

FIG 1 zeigt eine schematische Darstellung eines ersten Verbindungsmoduls 1. Das zweite Verbindungsmodul ist vorzugsweise baugleich zum dargestellten ersten Verbindungsmodul 1 ausgebildet. Das erste Verbindungsmodul 1 weist zur mechanischen und elektrischen Verbindung mit einem Gerät, insbesondere einem Sicherheitsschaltgerät, auf seiner ersten Seite 10 ein erstes Anschlussmittel 2 und zwei Schnappvorrichtungen 23 auf. Die mechanische lösbare Verbindung des Geräts mit dem Verbindungsmodul erfolgt insbesondere mittels eines Schnappmechanismus. Zur Aufnahme und Führung des Gerätes im Verbindungsmodul 1 weist das Verbindungsmodul 1 an seiner Schnappvorrichtung 23 jeweils zwei Nuten 29 auf. Durch die Aufnahme des Gerätes im Verbindungsmodul 1 verrastet jeweils die Schnappnase 24 der Schnappvorrichtung 23 mit einem zugehörigen Schnappnasengegenspieler am Gerät. Der Schnappnasengegenspieler ist insbesondere durch eine Vertiefung am Gerät ausgebildet. Zum Lösen eines aufgenommenen Gerätes vom Verbindungsmodul 1 können die Schnappvorrichtungen 23 jeweils über ein Aufnahmemittel 25 ausgelenkt werden, so dass die mechanische Verrastung zwischen dem Gerät und dem Verbindungsmodul 1 gelöst wird.

Durch das mechanische Aufnehmen des Geräts im Verbindungsmodul 1 erfolgt das elektrische Kontaktieren des ersten Anschlussmittels 9 mit dem Gerät. Hierfür umfasst das erste Anschlussmittel Kontaktelemente, welche durch das Aufnehmen des Geräts im Verbindungsmodel mit Kontaktstellen des Gerätes kontaktiert werden, so dass eine elektrisch leitende Verbindung zwischen den Kontaktelementen und den zugehörigen Kontaktstellen vorliegt. Das erste Anschlussmittel 2 umfasst vierzehn Kontaktelemente 9, wovon sieben erste Kontaktelemente 9 sieben zweite Kontaktelemente 9 gegenüberliegend angeordnet sind. Die einzelnen Kontaktelemente 9 sind im ersten Anschlussmittel 2 voneinander galvanisch getrennt. Die elektrische Kontaktierung des Geräts zum ersten Anschlussmittel erfolgt über eine Leiterplatte des Geräts. Die Leiterplatte weist hierfür je Kontaktelement 9 des ersten Anschlussmittels 2 eine elektrisch leitende Kontaktfläche auf der Außenseite der Leiterplatte auf. Durch das Aufnehmen des Geräts im Verbindungsmodul 1 wird ein Teil der Leiterplatte in das erste Anschlussmittel 2 bewegt, so dass die Leiterplatte mit ihren Kontaktflächen zwischen den gegenüberliegenden sieben Kontaktelementen 9 derart angeordnet ist, dass jedes Kontaktelement 9 des ersten Anschlussmittels 2 eine separate Kontaktfläche der Leiterplatte elektrisch leitend kontaktiert.

Die erste Seite 10 sowie die der ersten Seite 10 gegenüberliegende zweite Seite 11 des Verbindungsmoduls 1 weist ein Befestigungsmittel 18 auf. Das Befestigungsmittel 18 ist durch zwei Öffnungen 18 ausgebildet. Das Verbindungsmodul 1 kann somit mittels der zwei Öffnungen 18 mit zwei Schrauben z.B. an einer Wand befestigt werden. Anschließend kann das Gerät aufgenommen werden, so dass das Gerät über das Verbindungsmodul 1 an der Wand befestigt ist.

Alternativ zur Befestigung des Verbindungsmoduls 1 über das Befestigungsmittel 18 weist das Verbindungsmodul 1 auf seiner zweiten Seite 11 eine Hutschienenaufnahme 20 auf. Die Hutschienenaufnahme 20 wird insbesondere durch ein Hutschienenrastmittel auf der zweiten Seite 11 ausgebildet. Mittels des Hutschienenrastmittels 20 kann das Verbindungsmodul 1 über seine zweite Seite 11 mit einer Hutschiene mechanisch lösbar verrastet werden.

Zwischen der ersten und zweiten Seite 10,11 des Verbindungsmoduls 1 sind mehrere Öffnungen 26 angebracht. Mittels der Öffnungen 26 kann bei einem aufgenommen Gerät ein optimierter Wärmeabtransport vom Gerät erfolgen.

Das Verbindungsmodul 1 weist auf einer dritten Seite 12 zweite Anschlussmittel 3 auf. Das zweite Anschlussmittel 3 ragt hierbei aus der dritten Seite 12 heraus. Ferner sind an der dritten Seite 12 Stifte 17 angeordnet, welcher der mechanischen Verbindung des Verbindungsmoduls 1 mit einem weiteren Verbindungsmodul (welches baugleich zum ersten Verbindungsmodul 1 ist) dienen. Das erste Verbindungsmodul 1 weist hierfür an seiner vierten Seite 13, welche der dritten Seite 12 gegenüber liegt, entsprechende Aussparungen auf, so dass mittels der Stifte 17 und der Aussparung sowohl eine Führung beim Koppeln zweier Verbindungsmodule 1 als auch ein mechanischer Kraftaustausch zwischen zwei miteinander gekoppelten Verbindungsmodulen 1 erfolgt.

Das zweite Anschlussmittel 3 umfasst sieben Kontaktelemente 9, welche jeweils als Kontaktstift ausgebildet sind, und eine Schnappnase 7 auf. Jeder der sieben Kontaktelemente 9 des zweiten Anschlussmittels 3 ist mit jeweils einem Kontaktelement 9 der sieben ersten Kontaktelemente 9 des ersten Anschlussmittels 2 geräteintern verbunden. Es liegen somit sieben geräteinterne galvanisch getrennte Verbindungen zwischen dem ersten Anschlussmittel 2 und dem zweiten Anschlussmittel 3 vor, wobei je Kontaktelement 9 der ersten Kontaktelemente 9 des ersten Anschlussmittels 2 eine elektrisch leitende Verbindung zu einem separaten Kontaktelement 9 des zweiten Anschlussmittels 3 hergestellt ist.

Das Verbindungsmodul 1 weist auf der vierten Seite 13 dritte Anschlussmittel 4 auf. Das dritte Anschlussmittel 4 ist durch eine Vertiefung an der vierten Seite 13 ausgebildet. Die Vertiefung ist derart ausgebildet, dass sie beim Verschnappen zweier Verbindungsmodule 1 mit dem aus der dritten Seite 12 herausragenden zweiten Anschlussmittel 3 des anderen Verbindungsmoduls 1 derart korrespondiert, dass das zweite Anschlussmittel 3 im dritten Anschlussmittel 4 aufgenommen wird.

Das dritte Anschlussmittel 4 umfasst sieben Kontaktelemente 9, welche jeweils als Kontaktbuchse zur Aufnahme eines Kontaktstiftes der zweiten Anschlussmittel 3 ausgebildet sind, und einen Schnappnasengegenspieler 8, welcher als Lasche ausgebildet ist. Jeder der sieben Kontaktelemente 9 des dritten Anschlussmittels 4 ist mit jeweils einem Kontaktelement 9 der sieben zweiten Kontaktelemente 9 des ersten Anschlussmittels 2 geräteintern verbunden. Es liegen somit sieben geräteinterne galvanisch getrennte Verbindungen zwischen dem ersten Anschlussmittel 2 und dem dritten Anschlussmittel 4 vor, wobei je Kontaktelement 9 der ersten Kontaktelemente 9 des ersten Anschlussmittels 2 eine elektrisch leitende Verbindung zu einem separaten Kontaktelement 9 des dritten Anschlussmittels 4 hergestellt ist.

Sofern kein Gerät im Verbindungsmodul 1 aufgenommen ist, sind die Kontakte 9 des zweiten Anschlussmittels 3 nicht mit den Kontakten 9 des dritten Anschlussmittels 4 verbunden. Ist ein Gerät im Verbindungsmodul 1 aufgenommen, so liegt in Abhängigkeit des Schaltzustandes des aufgenommenen Gerätes eine elektrisch leitende Verbindung zwischen den Kontaktelementen 9 des zweiten und dritten Anschlussmittels 3,4 vor.

Das erste Verbindungsmodul 1 kann mit einem baugleichen Verbindungsmodul 1 gekoppelt und verrastet werden. Hierfür wird das erste Verbindungsmodul 1 mit seiner dritten Seite 12 auf die vierte Seite 13 des weiteren Verbindungsmoduls 1 geschoben, so dass das zweite Anschlussmittel 3 in das dritte Anschlussmittel 4 geschoben wird. Hierbei wird durch die Schnappnase 7 des zweiten Anschlussmittels 3 die Lasche 8 des dritten Anschlussmittels 4 zunächst in Richtung des Bereichs, welcher durch ein aufgenommenes Gerät eingenommen wird, ausgelenkt, bis die Schnappnase7 in die Öffnung der Lasche 8 einrastet.

Zum mechanischen Trennen der zweier miteinander verrasteter Verbindungsmodule 1 muss die Lasche 8 angehoben werden, so dass das zweite Anschlussmittel 3 aus dem dritten Anschlussmittel 4 herausgezogen werden kann.

Durch das Koppeln der zweier Verbindungsmodule 1 werden die Kontaktstifte 9 des zweiten Anschlussmittels 3 in die zugehörigen Kontaktbuchsen 9 des dritten Anschlussmittels 4 geschoben, so dass eine elektrisch leitende Verbindung zwischen den ersten Anschlussmitteln 2 beider Verbindungsmodule hergestellt ist.

FIG 2 zeigt eine weitere schematische Darstellung des ersten Verbindungsmoduls 1 der FIG 1. Bei dem dargestellten Verbindungsmodul 1 wurde lediglich ein Gehäuseteil der ersten Seite 10 des Verbindungsmoduls 1 entfernt, so dass die Kontaktelemente 9 des zweiten und dritten Anschlussmittels 3,4 sichtbar sind. Die Kontaktelemente 9 des zweiten und dritten Anschlussmittels 3,4 sind auf einer Leiterplatte 27 montiert und über diese mit den Kontaktelementen 9 des ersten Anschlussmittels 2 verbunden. Die Kontaktelemente 9 des zweiten Anschlussmittels 3 sind jeweils Kontaktstifte 9. Die Kontaktelemente 9 des dritten Anschlussmittels 4 sind Kontaktbuchsen, welche Kontaktstifte 9 des zweiten Anschlussmittels 3 eines baugleichen weiteren Verbindungsmoduls 1 aufnehmen können.

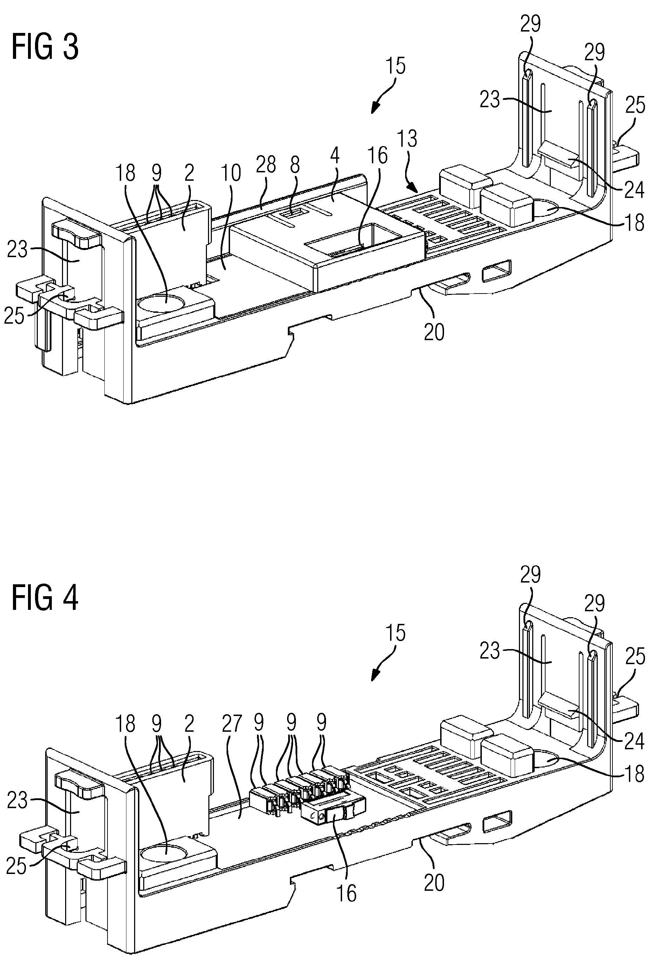

FIG 3 zeigt eine schematische Darstellung eines dritten Verbindungsmoduls 15. FIG 4 zeigt eine weitere schematische Darstellung des dritten Verbindungsmoduls 15 der FIG 3. Bei der FIG 4 wurde lediglich ein Gehäuseteil der ersten Seite 10 des dritten Verbindungsmoduls 15 entfernt. Das dritte Verbindungsmodul 15 ist nahezu baugleich zum ersten Verbindungsmodul der Figuren 1 und 2 ausgebildet. Das dritte Verbindungsmodul 15 kann die gleichen Geräte aufnehmen, wie das erste Verbindungsmodul. Ferner kann das dritte Verbindungsmodul 15 über seine vierte Seite 13 mit einem ersten Verbindungsmodul, insbesondere über dessen dritte Seite, gekoppelt werden, so dass das dritte Anschlussmittel 4 des dritten Verbindungsmoduls 15 mit dem zweiten Anschlussmittel des ersten Verbindungsmoduls verrastet ist. Im Vergleich zum ersten Verbindungsmodul gemäß der Figuren 1 und 2 weist das dritte Verbindungsmodul 15 kein drittes Anschlussmittel auf. Anstelle des dritten Anschlussmittels umfasst das dritte Verbindungsmodul 15 ein Abschlussmittel 16. Ferner ist vor dem zweiten Anschlussmittel 4 eine Verblendung 28 angebracht und das dritte Verbindungsmodul 15 weist rechtsseitig keine überstehenden Konturen (z.B. die Stifte des ersten Verbindungsmoduls) auf, so dass ein dichtes Anbauen eines nächsten Gerätes ermöglicht wird. Das dritte Verbindungsmodul 15 wird insbesondere als Abschlussmodul bei dem Verbindungssystem eingesetzt. Das erste Verbindungsmodul kann jeweils mit mehreren weiteren ersten Verbindungsmodulen gekoppelt werden, so dass Signale stets von einem Verbindungsmodul zum nebengeordneten Verbindungsmodul ausgetauscht werden können. Auf diese Weise können mehrere Geräte mechanisch und elektrisch leitend miteinander verbunden werden. Mittels des dritten Verbindungsmoduls 15 können mittels des Abschlussmittels 16, welcher als Schalter ausgebildet ist, über das dritte Anschlussmittel 4 des dritten Verbindungsmoduls 15 empfangene Signale zum dritten Anschlussmittel 4 des dritten Verbindungsmoduls 15 zurückgeführt werden. Insbesondere werden in Abhängigkeit der Schalterstellung des Schalters 16 jeweils zwei Kontaktelemente 9 der zweiten Kontaktelemente 9 des ersten Anschlussmittels 2 miteinander verbunden oder nicht.

In Abhängigkeit des jeweiligen Einsatzortes (z.B. Abschluss Grundgerät oder Kontakterweiterung) kann somit über den Schalter 16 die erforderliche Schaltstellung für das durch die Geräte gebildete Sicherheitssystem gewählt werden.

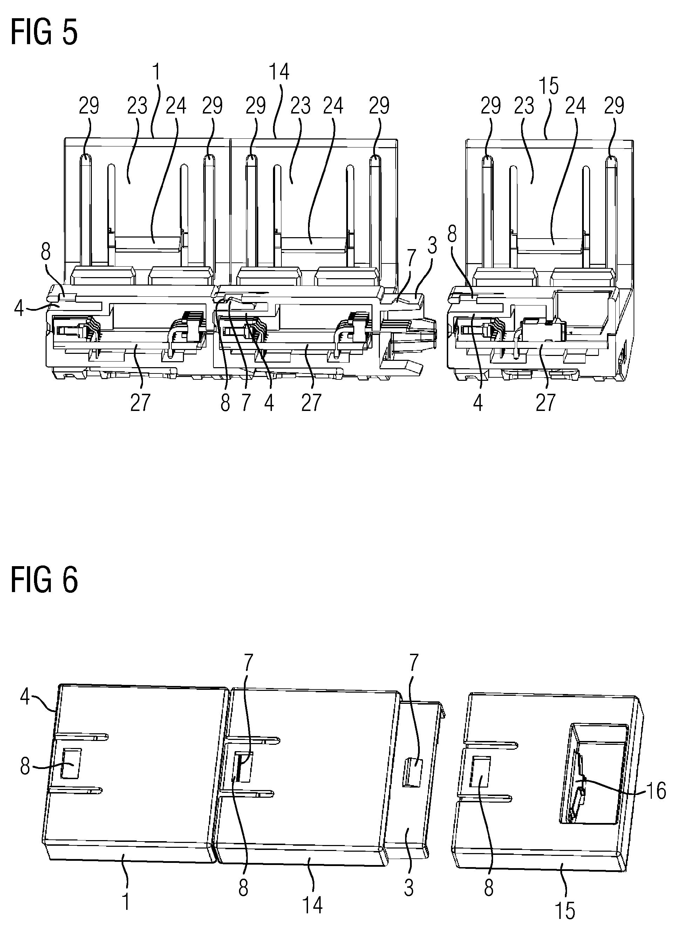

FIG 5 zeigt eine schematische Darstellung eines Schnittbildes von drei Verbindungsmodulen 1,14,15. FIG 6 zeigt eine schematische Darstellung eines Ausschnitts einer Draufsicht der drei Verbindungsmodule 1,14,15 der FIG 5. Zu sehen ist ein erstes Verbindungsmodul 1 gemäß den Figuren 1 und 2, ein zweites Verbindungsmodul 14, welches baugleich zum ersten Verbindungsmodul 1 ausgebildet ist, und ein drittes Verbindungsmodul 15 gemäß den Figuren 3 und 4. Das erste Verbindungsmodul 1 ist mit dem zweiten Verbindungsmodul 14 verrastet, d.h. das zweite Anschlussmittel 3, insbesondere dessen Schnappnase 7, des ersten Verbindungsmoduls 1 ist mit dem dritten Anschlussmittel 4, insbesondere mit dessen Schnappnasengegenspieler 8, des zweiten Verbindungsmoduls 14 verrastet. Die beiden Verbindungsmodule 1,14 sind somit mechanisch miteinander fest verbunden. Durch das Koppeln des ersten Verbindungsmoduls 1 mit dem zweiten Verbindungsmodul 14 wurden ferner die Kontaktelemente des zweiten Anschlussmittels 3 des ersten Verbindungsmoduls 1 mit den zugehörigen Kontaktelementen des dritten Anschlussmittels 4 des zweiten Verbindungsmoduls 14 elektrisch leitend verbunden.

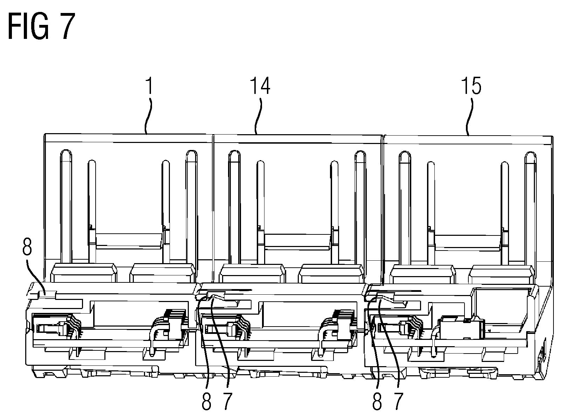

Das dritte Verbindungsmodul 15 ist noch nicht mit dem rechtsseitigen Teil (der dritten Seite 12) des zweiten Verbindungsmoduls 14 gekoppelt. Zum Koppeln des zweiten Verbindungsmoduls 14 mit dem dritten Verbindungsmodul 15 muss das zweite Anschlussmittel 3 des zweiten Verbindungsmoduls 14 in das dritte Anschlussmittel 4 des dritten Verbindungsmoduls 15 geschoben werden. Durch das Hineinschieben des zweiten Anschlussmittels 3 des zweiten Verbindungsmoduls 14 wird durch die Schnappnase 7 des zweiten Anschlussmittels 3 ein Teil des dritten Anschlussmittels 4 ausgelenkt. Erst wenn die Schnappnase 7 in die Öffnung 8 (Schnappnasengegenspieler) des dritten Anschlussmittels 4 ragt, nimmt der ausgelenkte Teil des dritten Anschlussmittels 4 seine ursprüngliche Position ein. Die Schnappnase 7 ist somit über die Öffnung 8 verrastet, so dass eine mechanisch stabile Verbindung zwischen dem zweiten und dritten Verbindungsmodul 14,15 hergestellt ist. Dieser Zustand ist durch FIG 7 gezeigt. In der FIG 7 ist das erste Verbindungsmodul 1 mit dem zweiten Verbindungsmodul 14 und das zweite Verbindungsmodul 14 mit dem dritten Verbindungsmodul 15 verrastet.

Zum Lösen zweier Verbindungsmodule 1,14,15 muss jeweils der Teil des zweiten Anschlussmittels 4 ausgelenkt werden, welcher beim Verrastvorgang durch die Schnappnase 7 ausgelenkt wird. Sobald jedoch z.B. das zweite Verbindungsmodul 14 mit einem Gerät gekoppelt ist, d.h. über die Nuten 29 wird das Gerät auf die erste Seite das zweite Verbindungsmoduls 14 geschoben, bis die Schnappnase 24 des Verbindungsmoduls 14 mit der entsprechenden Aussparung am Gerät verrastet, kann das zweite Verbindungsmodul 14 nicht mehr vom ersten Verbindungsmodul 1 getrennt werden, da der Teil des zweiten Anschlussmittels 4, welcher beim Verrastvorgang ausgelenkt wird, nicht mehr ausgelenkt werden.

Das aufgenommene Gerät nimmt somit beim entsprechenden Verbindungsmodul 1,14,15 den Raum ein, welcher beim Koppelvorgang des dritten Anschlussmittel 4 mit dem nebengeordneten zweiten Anschlussmittel 3 zum Auslenken des Teils des dritten Anschlussmittels 4 benötigt wird.

Sobald das Unterteil des Gerätes mit dem Verbindungsmodul 1,14,15 gekoppelt ist, ist ein Trennen des Verbindungsmoduls 1,14,15 vom linksseitigen Verbindungsmodul 1,14 nicht mehr möglich, da das Unterteil des Geräts das Öffnen der Lasche 8 verhindert. Zum Trennen des Verbindungsmoduls 1,14,15 vom linksseitig gekoppelten Verbindungsmodul 1,14 muss somit zunächst das Gerät vom Verbindungsmodul 1,14,15 entfernt werden.

Ein auf einem Verbindungsmodul 1,14,15 montiertes Gerät verhindert somit das Anheben des Schnappnasengegenspielers 8 (hier Lasche) des dritten Anschlussmittels 4 des Verbindungsmoduls 1,14,15, so dass ein Ausrasten des Schnapphakens 7 aus der Lasche 8 verhindert wird. Ist kein Gerät auf dem Verbindungsmodul 1,14,15 montiert, so kann das entsprechende Verbindungsmodul 1,14,15 demontiert werden.

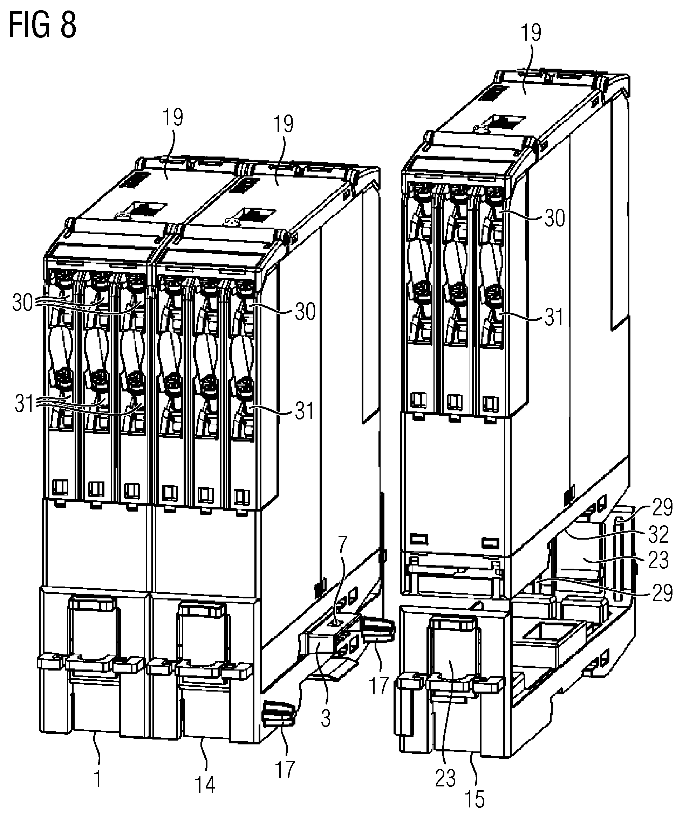

FIG 8 zeigt eine schematische Darstellung eines Systems mit drei Verbindungsmodulen 1,14,15 und drei Geräten 19. Das erste Verbindungsmodul 1 und zweite Verbindungsmodul 14 entspricht dem in den Figuren 1 und 2 gezeigten Verbindungsmodul. Das dritte Verbindungsmodul 15 entspricht dem in den Figuren 3 und 4 gezeigten Verbindungsmodul. Das Gerät 19 ist jeweils ein Sicherheitsschaltgerät, wobei das mit dem ersten Verbindungsmodul 1 gekoppelte Gerät 19 ein Grundgerät 19 ist, welches eine Verarbeitungseinheit umfasst und die Sicherheitseingänge 30 und Sicherheitsausgänge 31 der Geräte 19 ansteuert und überwacht. Im Grundgerät 19 erfolgen die Freigabe des Freigabekreises sowie die Überwachung des Rückführkreises. Das Grundgerät 19 selbst weist ebenso Sicherheitseingänge 30 und Sicherheitsausgänge 31 auf. Mittels der Sicherheitseingänge können Signale von Aktoren und Sensoren erfasst werden. Mittels der Sicherheitsausgänge 31 können insbesondere Signale an Schaltgeräte (z.B. Schütz, oder Relais) ausgegeben werden.

Das mit dem zweiten Verbindungsmodul 14 gekoppelte Gerät 19 ist ein Erweiterungsmodul 19 des Grundgeräts 19. Durch das Erweiterungsmodul 19 kann die Anzahl der durch das Grundgerät 19 bereitgestellten Sicherheitseingänge 30 und Sicherheitsausgänge 31 erweitert werden. Im Erweiterungsmodul 19 selbst findet keine logische Auswertung der über die Sicherheitseingänge 30 des Erweiterungsmoduls 19 empfangenen Signale statt. Das Erweiterungsmodul 19 leitet derartige Signale über die Verbindung zum ersten Anschlussmittel des zweiten Verbindungsmoduls 14 an das Grundgerät 19, so dass dieses das Signal auswerten und entsprechend reagieren kann. Das Erweiterungsmodul 19 weist ferner Sicherheitsausgänge 31 auf, über welche Schaltgeräte angesteuert werden können. Die Signale hierfür stammen vom Grundmodul 19 und werden über das erste und zweite Verbindungsmodul 1,14 zum Erweiterungsmodul 19 des zweiten Verbindungsmodul gesandt. Die Signale des Grundgerätes werden durch das Erweiterungsmodul 19 nicht ausgewertet. Durch die Verbindungsmodule 1,14,15 wird die Kommunikation zwischen den Geräten 19 ermöglicht. Insbesondere wird die Kommunikation bezüglich des Freigabekreises und Rückführkreises des Grundmoduls 19 über die elektrische Verbindung der Geräte 19 zu den Verbindungsmodulen 1,14,15 (mittels des ersten Anschlussmittels) und der Verbindungsmodule miteinander (mittels der zweiten und dritten Anschlussmittel) geführt.

Das dritte Verbindungsmodul 15 ist noch nicht mit dem zweiten Verbindungsmodul 14 gekoppelt. Ferner ist das Gerät 19 des dritten Verbindungsmoduls 15 noch nicht mit dem dritten Verbindungsmodul 14 gekoppelt. Das Gerät 19 des dritten Verbindungsmoduls 15 ist ebenso ein Erweiterungsmodul 19 mit Sicherheitseingängen 30 und Sicherheitsausgängen 31.

Mittels der Verbindungsmodule 1,14,15 wird somit die elektrische Verbindung untereinander sowie zu den aufgenommenen Geräten 19 hergestellt, so dass eine Einzelverdrahtung der Geräte 19 untereinander entfallen kann.

Die Kontaktelemente der Verbindungsmodule 1,14,15 sind durch Konturen an den Kunststoffteilen der Anschlussmittel vor Beschädigung geschützt.

Mittels Kunststoffzapfen 17 und korrespondierende Öffnungen werden die Verbindungsmodule 1,14,15 mechanisch zueinander positioniert. Durch die Rastverbindung zwischen den Verbindungsmodulen über das zweite Anschlussmittel 3 mit dem dritten Anschlussmittel werden die Verbindungsmodule 1,14,15 formschlüssig zueinander in Position gehalten. Die Rastverbindung kann durch die aufgesteckten Geräte 19 verriegelt werden, so dass sich der Verband der Verbindungsmodule 1,14, 15 im Betrieb nicht trennen kann.

Weiterhin verfügen die Verbindungsmodule 1,14,15 über Schraubbefestigungspunkte (Befestigungsmittel), mittels derer das Verbindungsmodul 1,14,15 an eine Wand geschraubt werden kann.

Das dritte Verbindungsmodul 15 dient dem Abschluss des Verbindungssystems.

Bei den Geräten 19 handelt es sich um Standardgeräte die über eine am Gerät 19 integrierte Hutschienenaufnahme 32 auch ohne das Verbindungssystem 1,14,15 auf eine Hutschiene gerastet werden können.

Zur Aufnahme eines Gerätes 19 im Verbindungsmodul 1,14,15 wird das Gerät 19 über entsprechende Nuten 29 am Verbindungsmodul 1,14,15 geführt. Das Gerät 19 verrastet mit der an der Ober- und Unterseite des Verbindungsmoduls 1,14,15 angebrachter Schnappvorrichtung 23. Die Verbindung zwischen den einzelnen Geräten 19 mit dem Verbindungsmodul 1,14,15 erfolgt über eine Steckverbindung zum ersten Anschlussmittel. Hierbei taucht eine Leiterplatte mit elektrisch leitenden Kontaktflächen im ersten Anschlussmittel des Verbindungsmoduls derart ein, dass die Kontaktflächen der Leiterplatte in direktem Kontakt zu den Kontaktelementen des ersten Anschlussmittels stehen. Die Kontaktelemente des ersten Anschlussmittels sind insbesondere federnd gelagert. Ferner sind die elektrisch leitenden Kontaktflächen beidseitig auf der Leiterplatte angeordnet. Die Kontaktstellen sind vorzugsweise mit Sn oder Au beschichtet.

Durch das Verbindungssystem wird eine geschützte Verlegung der Geräteverbindungsleitungen erreicht. Hierdurch können bei Anwendungen im Sicherheitstechnikbereich Fehler (z.B. abvibrierte Leitungen, fehlerhafte Klemmstellen) ausgeschlossen werden. Bei der Montage können Verdrahtungsfehler für die Verbindung zwischen den Geräten 19 ausgeschlossen werden. Dies reduziert den Aufwand für Fehlersuche und Fehlerbehebung beim Installateur. Durch die Gestaltung der Verbindungsmodule 1,14,15 können Geräte 19 nach vorne aus dem Verband demontiert werden, ohne dass der gesamte Geräteverband aus dem Schaltschrank entfernt werden muss.

Die Verbindungsmodule 1,14,15 sowie die Geräte 19 sind so ausgebildet, dass sie auf einer 35 mm Hutschiene (flache tiefe = 15 mm und hohe Schiene tiefe = 7,5 mm) oder mittels einer Wandmontage (durch Verschraubung) ohne Zusatzteile montiert werden können.

Durch die Zwangsverriegelung zwischen den Verbindungsmodulen 1,14,15 wird sicher verhindert, dass der Verband ungewollt getrennt wird. Gleichzeitig ist das Trennen des Verbandes bei gezogenen Geräten leicht möglich.

Das Verbindungssystem kann ebenso als stehende Verdrahtung (Platzhalter) im Schaltschrank ohne Geräte eingebaut werden.

## Patentansprüche

1. Verbindungssystem für elektrisches Geräte (19), mit einem ersten und einem zweiten Verbindungsmodul (1,14), welches jeweils ein erstes Anschlussmittel (2) aufweist, wobei das erste Verbindungsmodul (1) ein zweites Anschlussmittel (3) aufweist und das zweite Verbindungsmodul (14) ein drittes Anschlussmittel (4) aufweist, wobei das erste und zweite Verbindungsmodul (1,14) jeweils ein Gerät (19) aufnehmen kann, so dass im gekoppelten Zustand des Geräts (19) mit dem Verbindungsmodul (1,14) eine unmittelbare elektrische Verbindung zwischen dem ersten Anschlussmittel (2) des Verbindungsmoduls (1,14) und dem aufgenommenen Gerät (19) und eine unmittelbare mechanische Verbindung zwischen dem Verbindungsmodul (1,14) und dem aufgenommenen Gerät (19) vorliegt, wobei das erste Verbindungsmodul (1) mit seinem zweiten Anschlussmittel (3) unmittelbar mit dem dritten Anschlussmittel (4) des zweiten Verbindungsmoduls (14) verrastet werden kann, so dass im verrasteten Zustand das erste Verbindungsmodul (1) elektrisch und mechanisch mit dem zweiten Verbindungsmodul (14) verbunden ist, wobei das dritte Anschlussmittel (4) derart angeordnet und ausgebildet ist, dass im verrasteten Zustand des zweiten Anschlussmittels (3) mit dem dritten Anschlussmittel (4) ein mechanisches und elektrisches Trennen des ersten Verbindungsmoduls (1) von dem zweiten Verbindungsmodul (14) verhindert wird, wenn das zweite Verbindungsmodul (14) ein Gerät (19) aufgenommen hat, **dadurch gekennzeichnet, dass** das zweite Anschlussmittel (3) eine Schnappnase (7) aufweist, welche in einen Schnappnasengegenspieler (8) des dritten Anschlussmittels (4) einrasten kann, wobei während des mechanischen Koppelns des ersten Verbindungsmoduls (1) mit dem zweiten Verbindungsmodul (14) der Schnappnasengegenspieler (8)in einen Bereich ausgelenkt wird, welcher durch das aufgenommene Gerät (19) eingenommen wird.

2. Verbindungssystem nach Anspruch 1, wobei das erste Verbindungsmodul (1) baugleich zum zweiten Verbindungsmodul (14) ist.

3. Verbindungssystem nach einem der vorhergehenden Ansprüche, wobei das erste und zweite Verbindungsmodul (1,14) jeweils ein Rastmittel (24) umfasst, mittels welchem die unmittelbare mechanische Verbindung zu dem Gerät (19) herstellbar ist.

4. Verbindungssystem nach einem der vorhergehenden Ansprüche, wobei das erste und zweite Verbindungsmodul (1,14) jeweils eine Hutschienenaufnahme (20) aufweist.

5. Verbindungssystem nach einem der vorhergehenden Ansprüche, wobei die unmittelbare mechanische Verbindung zwischen dem ersten Verbindungsmodul (1) mit dem zweiten Verbindungsmodul (14) mittels einer lösbaren Schnappverbindung (7,8) erfolgt.

6. Verbindungssystem nach einem der vorhergehenden Ansprüche, wobei das zweite und dritte Anschlussmittel (3,4) jeweils mindestens zwei elektrische Kontaktelemente (9), welche jeweils geräteintern zu einem Kontaktelement (9) des ersten Anschlussmittels (2) geführt sind, umfasst.

7. Verbindungssystem nach einem der vorhergehenden Ansprüche, mit einem dritten Verbindungsmodul (15), welches ein erstes Anschlussmittel (2) aufweist, wobei das dritte Verbindungsmodul (15) ein Gerät (19) aufnehmen kann, so dass im gekoppelten Zustand des Geräts (19) mit dem dritten Verbindungsmodul (15) eine unmittelbare elektrische Verbindung zwischen dem ersten Anschlussmittel (2) des dritten Verbindungsmoduls (15) und dem aufgenommenen Gerät (19) und eine unmittelbare mechanische Verbindung zwischen dem dritten Verbindungsmodul (15) und dem aufgenommenen Gerät (19) vorliegt, wobei das dritte Verbindungsmodul (15) ein drittes Anschlussmittel (4) aufweist, wobei das zweite Anschlussmittel (3) des ersten oder zweiten Verbindungsmoduls (1,14) unmittelbar mit dem dritten Anschlussmittel (4) des dritten Verbindungsmoduls (15) verrastet werden kann, so dass im verrasteten Zustand das zweite Anschlussmittel (3) des ersten oder zweiten Verbindungsmoduls (1,14) elektrisch und mechanisch mit dem dritten Verbindungsmodul (15) verbunden ist, wobei das dritte Anschlussmittel (4) derart angeordnet und ausgebildet ist, dass im verrasteten Zustand des zweiten Anschlussmittels (3) mit dem dritten Anschlussmittel (4) ein mechanisches und elektrisches Trennen des zweiten Anschlussmittels (3) von dem dritten Verbindungsmodul (15) verhindert wird, wenn das dritte Verbindungsmodul (15) ein Gerät (19) aufgenommen hat, wobei das dritte Verbindungsmodul (15) ein Abschlussmittel (16) umfasst, mittels welchem elektrische Kontaktelemente (9) des ersten Anschlussmittels (2) miteinander verbunden werden können.

8. System mit einem Verbindungssystem nach einem der Ansprüche 1 bis 7 und einem ersten und zweiten Gerät (19), wobei das erste Gerät (19) mit dem ersten Verbindungsmodul (1) und das zweite Gerät (19) mit dem zweiten Verbindungsmodul (14) koppelbar sind.

9. System nach Anspruch 8, wobei das erste Gerät (19) ein Grundmodul und das zweite Gerät (19) ein Erweiterungsmodul ist, wobei im gekoppelten Zustand des Grundmoduls mit dem ersten Verbindungsmodul (1), des Erweiterungsmoduls mit dem zweiten Verbindungsmodul (14) und des ersten Verbindungsmoduls (1) mit dem zweiten Verbindungsmodul (14), das Grundmodul ein elektrisches Signal über das erste und zweite Verbindungsmodul (1,14) an das Erweiterungsmodul ausgeben kann.

10. System nach einem der Ansprüche 8 bis 9, wobei das erste und zweite Gerät (19) jeweils eine Leiterplatte (21) mit einer elektrisch leitenden Kontaktfläche (22) umfasst, wobei das elektrische Kontaktieren des Geräts (19) zum ersten Anschlussmittel (2) direkt über die elektrisch leitende Kontaktfläche (22) erfolgt.

11. System nach einem der Ansprüche 8 bis 10, wobei das Gerät (19) im Bereich seiner Hutschienenaufnahme (32) eine Kontaktstelle zum elektrischen Kontaktieren des Geräts (19) mit dem ersten Anschlussmittel (2) aufweist.

## Claims

1. Connection system for electrical devices (19), comprising a first and a second connection module (1,14) each having a first connection means (2), wherein the first connection module (1) has a second connection means (3) and the second connection module (14) a third connection means (4), wherein the first and the second connection module (1,14) can each accommodate a device (19) so that, when the device (19) and the connection module (1,14) are in the coupled state, there is a direct electrical connection between the first connection means (2) of the connection module (1,14) and the accommodated device (19) and a direct mechanical connection between the connection module (1,14) and the accommodated device (19), wherein the first connection module (1) can be locked directly by its second connection means (3) to the third connection means (4) of the second connection module (14) so that, in the coupled state, the first connection module (1) is electrically and mechanically connected to the second connection module (14), wherein the third connection means (4) is disposed and implemented such that, when the second connection means (3) and the third connection means (4) are in the coupled state, mechanical and electrical disconnection of the first connection module (1) from the second connection module (14) is prevented if the second connection module (14) has received a device (19), **characterised in that** the second connection means (3) has a snap lug (7) which can latch into a snap lug counterpart (8) of the third connection means (4), wherein the snap lug counterpart (8) is deflected into a region which is occupied by the received device (19) during mechanical coupling of the first connection module (1) to the second connection module (14).

2. Connection system according to claim 1, wherein the first connection module (1) is of identical construction to the second connection module (14).

3. Connection system according to one of the preceding claims, wherein the first and second connection module (1,14) each comprise a latching means (24) by means of which the direct mechanical connection to the device (19) can be established.

4. Connection system according to one of the preceding claims, wherein the first and second connection module (1,14) each have a top-hat rail mount (20).

5. Connection system according to one of the preceding claims, wherein the direct mechanical connection between the first connection module (1) and the second connection (14) is in the form of a detachable snap-on connection (7,8).

6. Connection system according to one of the preceding claims, wherein the second and third connection means (3,4) each comprise at least two electrical contact elements (9) which are each guided inside the device to a contact element (9) of the first connection means (2).

7. Connection system according to one of the preceding claims, comprising a third connection module (15) which has a first connection means (2), and the third connection module (15) can accommodate a device (19) so that when the device (19) and the third connection module (15) are in the coupled state, there is a direct electrical connection between the first connection means (2) of the third connection module (15) and the accommodated device (19) and a direct mechanical connection between the third connection module (15) and the accommodated device (19), wherein the third connection module (15) has a third connection means (4), wherein the second connection means (3) of the first or second connection module (1,14) can be directly locked to the third connection means (4) of the third connection module (15) so that, in the locked state, the second connection means (3) of the first or second connection module (1,14) is electrically and mechanically connected to the third connection module (15), wherein the third connection means (4) is disposed and implemented such that, when the second connection means (3) and the third connection means (4) are in the locked state, mechanical and electrical separation of the second connection means (3) from the third connection module (15) is prevented if the third connection module (15) has received a device (19), wherein the third connection module (15) comprises a termination means (16) enabling electrical contact elements (9) of the first connection means (2) to be interconnected.

8. System having a connection system according to one of claims 1 to 7 and a first and second device (19), wherein the first device (19) can be coupled to the first connection module (1) and the second device (19) to the second connection module (14).

9. System according to claim 8, wherein the first device (19) is a basic module and the second device (19) an expansion module, wherein in the coupled state of the basic module to the first connection module (1), of the expansion module to the second connection module (14) and of the first module (1) to the second connection module (14), the basic module can output an electrical signal to the expansion module via the first and second connection module (1,14).

10. System according to one of claims 8 to 9, wherein the first and second device (19) each comprise a circuit board (21) having an electrically conductive contact surface (22), wherein the device (19) is in direct electrical contact with the first connection point (2) via the electrically conductive contact surface (22).

11. System according to one of claims 8 to 10, wherein, in the region of its top-hat rail mount (32), the device (19) has a contact point for establishing electrical contact between the device (19) and the first connection means (2).

## Revendications

1. Système de liaison pour des appareils ( 19 ) électriques comprenant un premier et un deuxième modules ( 1, 14 ) de liaison, qui ont respectivement un premier moyen ( 2 ) de connexion, le premier module ( 1 ) de liaison ayant un deuxième moyen ( 3 ) de connexion et le deuxième module ( 14 ) de liaison ayant un troisième moyen ( 4 ) de connexion, le premier et le deuxième modules ( 1, 14 ) de liaison pouvant recevoir respectivement un appareil ( 19 ), de manière à ce qu'il y ait, lorsque l'appareil ( 19 ) est à l'état couplé au module ( 1, 14 ) de liaison, une liaison électrique directe entre le premier moyen ( 2 ) de connexion du module ( 1, 14 ) de liaison et l'appareil ( 19 ) qui est reçu et une liaison mécanique directe entre le module ( 1, 14 ) de liaison et l'appareil ( 19 ) qui est reçu, le premier module ( 1 ) de liaison pouvant, par son deuxième moyen ( 3 ) de connexion, être encliqueté directement avec le troisième moyen ( 4 ) de connexion du deuxième module ( 14 ) de liaison de manière à ce que, dans l'état encliqueté, le premier module ( 1 ) de liaison soit relié électriquement et mécaniquement au deuxième module ( 14 ) de liaison, le troisième moyen ( 4 ) de connexion étant disposé et constitué de manière à empêcher, à l'état encliqueté du deuxième moyen ( 3 ) de connexion avec le troisième moyen ( 4 ) de connexion, le premier module ( 1 ) de liaison de se séparer mécaniquement et électriquement du deuxième module ( 14 ) de liaison, si le deuxième module ( 14 ) de liaison a reçu un appareil ( 19 ) **caractérisé en ce que** le deuxième moyen ( 3 ) de connexion a un bec ( 7 ) à déclic, qui peut s'encliqueter dans un partenaire ( 8 ) de bec d'encliquetage du troisième moyen ( 4 ) de connexion, dans lequel, pendant l'accouplement mécanique du premier module ( 1 ) de liaison au deuxième module ( 14 ) de liaison, le partenaire ( 8 ) du bec d'encliquetage est dévié dans une région qui est occupée par l'appareil ( 19 ) qui est reçu.

2. Système de liaison suivant la revendication 1, dans lequel le premier module ( 1 ) de liaison est de construction pareille au deuxième module ( 14 ) de liaison.

3. Système de liaison suivant l'une des revendications précédentes, dans lequel le premier et le deuxième modules ( 1, 14 ) de liaison comprennent respectivement un moyen ( 24 ) d'encliquetage au moyen duquel la liaison mécanique directe à l'appareil ( 19 ) peut être produite.

4. Système de liaison suivant l'une des revendications précédentes, dans lequel le premier et le deuxième modules ( 1, 14 ) de liaison ont respectivement un logement ( 20 ) à profilé en chapeau.

5. Système de liaison suivant l'une des revendications précédentes, dans lequel la liaison mécanique directe entre le premier module ( 1 ) de liaison et le deuxième module ( 14 ) de liaison s'effectue au moyen d'une liaison ( 7, 8 ) amovible à déclic.

6. Système de liaison suivant l'une des revendications précédentes, dans lequel le deuxième et le troisième moyens ( 3, 4 ) de connexion comprennent respectivement au moins deux éléments ( 9 ) de contact électrique, qui vont respectivement d'une manière interne à l'appareil vers un élément ( 9 ) de contact du premier moyen ( 2 ) de connexion.

7. Système de liaison suivant l'une des revendications précédentes, comprenant un troisième module ( 15 ) de liaison, qui a un premier moyen ( 2 ) de connexion, le troisième module ( 15 ) de liaison pouvant recevoir un appareil ( 19 ), de manière à avoir, lorsque l'appareil ( 19 ) est à l'état couplé au troisième module ( 15 ) de liaison, une liaison électrique directe entre le premier moyen ( 2 ) de connexion du troisième module ( 15 ) de liaison et l'appareil ( 19 ) qui a été reçu et une liaison mécanique directe entre le troisième module ( 15 ) de liaison et l'appareil ( 19 ) qui a été reçu, le troisième module ( 15 ) de liaison ayant un troisième moyen ( 4 ) de connexion, le deuxième moyen ( 3 ) de connexion du premier ou du deuxième module ( 1, 14 ) de liaison pouvant être encliqueté directement avec le troisième moyen ( 4 ) de connexion du troisième module ( 15 ) de liaison, de manière à ce que, à l'état encliqueté, le deuxième moyen ( 3 ) de connexion du premier ou du deuxième module ( 1, 14 ) de liaison soit relié électriquement et mécaniquement au troisième module ( 15 ) de liaison, le troisième moyen ( 4 ) de connexion étant disposé et constitué de manière à ce que, à l'état encliqueté du deuxième moyen ( 3 ) de connexion avec le troisième moyen ( 4 ) de connexion, le deuxième moyen ( 3 ) de connexion soit empêché de se séparer mécaniquement et électriquement du troisième module ( 15 ) de liaison, si le troisième module ( 15 ) de liaison a reçu un appareil ( 19 ), le troisième module ( 15 ) comprenant un moyen ( 16 ) de terminaison, au moyen duquel des éléments ( 9 ) électriques de contact du premier moyen ( 2 ) de connexion peuvent être reliés entre eux.

8. Système comprenant un système de liaison suivant l'une des revendications 1 à 7 et un premier et un deuxième appareils ( 19 ), le premier appareil ( 19 ) pouvant être accouplé au premier module ( 1 ) de liaison et le deuxième appareil ( 19 ) au deuxième module ( 14 ) de liaison.

9. Système suivant la revendication 8, dans lequel le premier appareil ( 19 ) est un module de base et le deuxième appareil ( 19 ) est un module d'extension, dans lequel, lorsque le module de base est à l'état couplé au premier module ( 1 ) de liaison, le module d'extension est à l'état couplé au deuxième module ( 14 ) de liaison et le premier module ( 1 ) de liaison est à l'état couplé au deuxième module ( 16 ) de liaison, le module de base peut envoyer au module d'extension un signal électrique par le premier et le deuxième modules ( 1, 14 ) de liaison.

10. Système suivant l'une des revendications 8 à 9, dans lequel le premier et le deuxième appareils ( 19 ) comprennent respectivement une plaquette ( 21 ) à circuit imprimé ayant une surface ( 22 ) de contact conductrice de l'électricité, la mise en contact électrique de l'appareil ( 19 ) avec le moyen ( 2 ) de connexion s'effectuant directement par la surface ( 22 ) de contact conductrice de l'électricité.

11. Système suivant l'une des revendications 8 à 10, dans lequel l'appareil ( 19 ) a, dans la zone de son logement ( 32 ) à profil en chapeau, un point de contact pour la mise en contact électrique de l'appareil ( 19 ) avec le premier moyen ( 2 ) de connexion.
